Europäisches Patentamt

European Patent Office

Office européen des brevets

(19)

(11) Veröffentlichungsnummer: **0 007 004**
**B1**

(12) **EUROPÄISCHE PATENTSCHRIFT**

(45) Veröffentlichungstag der Patentschrift: **28.04.82**

(21) Anmeldenummer: **79101843.5**

(22) Anmeldetag: **11.06.79**

(51) Int. Cl.³: **G 01 R 31/28,**
**G 11 C 19/28, H 01 L 27/10**

(54) Prüfschaltung für Speicher aus Ladungskopplungselementen.

(30) Priorität: **13.07.78 US 924128**

(43) Veröffentlichungstag der Anmeldung:
**23.01.80 Patentblatt 80/2**

(45) Bekanntmachung des Hinweises auf die Patenterteilung:
**28.04.82 Patentblatt 82/17**

(84) Benannte Vertragsstaaten:
**DE FR GB**

(56) Entgegenhaltungen:
**DE - A - 2 311 034**
**DE - A - 2 723 594**
**US - A - 3 763 480**

(73) Patentinhaber: **International Business Machines Corporation**
**Armonk, N.Y. 10504 (US)**

(72) Erfinder: **Kelly, Helen Janet**
**52 Tor Road**
**Wappingers Falls New York 12590 (US)**
Erfinder: **Perlman, David Jacob**
**Neville Road**
**Wappingers Falls New York 12590 (US)**
Erfinder: **Satya, Akella Venkata Surya**
**38 Tor Road**
**Wappingers Falls New York 12590 (US)**

(74) Vertreter: **Rudolph, Wolfgang**
**Schönaicher Strasse 220**
**D-7030 Böblingen (DE)**

## Prüfschaltung für Speicher aus Ladungskopplungselementen

Die Erfindung betrifft eine Aufschaltung der im Oberbergriff des Anspruchs 1 angegebenen Art.

Ladungskopplungszellen sind eine populäre Form integrierter Halbleiter-Speicherzellen für den Speicher digitaler Datenprozessoren. Beispiele für derartige Speicher sind in der Literatur hinreichend beschrieben.

In der US-A-3 763 480 ist z.B. ein Speicher in seriell-parallel-serieller Struktur (SPS) beschrieben. In einer solchen SPS-Konfiguration wird ein Strom aus Datenbits in ein serielles Schieberegister aus Ladungskopplungszellen eingeleitet und von dort parallel in ein paralleles Speicherregister übertragen. Die Daten können dann parallel durch das parallele Register geschoben und parallel in ein serielles Ausgaberegister übertragen werden, von wo sie als serieller Bitstrom ausgeschoben werden.

In einer SPS-Konfiguration wird die Masse der Daten im allgemeinen im parallelen Teil gespeichert. Die seriellen Register dienen als Eingabe- bzw. Ausgaberegister. Strukturell stellt der parallele Teil eine große Anzahl von parallel gelegten seriellen Registern dar, die durch gemeinsame Taktleitungen so getaktet werden, daß die Information parallel durch den parallelen Teil geschoben wird. Die Nähe der einzelnen, den parallelen Teil bildenden seriellen Register ist eine kritische Einschränkung. Die bisherigen Überlegungen bei der Packungsdichte begünstigen eine möglichst dichte Packung der Register, so daß eine möglichst große Menge von Daten auf kleinstem Halbleiterraum gespeichert werden kann. Wenn zwei Register jedoch zu dicht nebeneinandergesetzt werden, ergibt sich ein Übersprechen, so daß die die Information enthaltende Ladung zwischen den Registern leckt und evt. verlorengeht. Andererseits stellt ein zu großer Abstand der Register voneinander eine Vergeudung von Halbleiterplatz der.

Zusätzlich zu dem oben erwähnten Registerabstand ändert sich auch das genannte Übersprechen mit Frequenz und Amplitude des Phasentaktes, mit der Amplitude des Eingangssignales, der Temperatur und den angelegten Spannungspegeln. Das Übersprechen kann auch beeinflußt werden durch die verschiedenen Verarbeitungsparameter bei der Herstellung von Registern mit Ladungskopplungs-Speicherzellen. Die Doteirungspegel des Substrates beeinflussen beispielsweise den zulässigen Abstand zwischen den Registern, die den parallelen Teil eines Speichers aus Ladungskopplungselementen, einen sogenannten CCD-Speicher, in SPS-Konfiguration bilden. Daraus ergab sich der Bedarf nach einer Prüfschaltung, die schnell und wirksam die Betriebscharakteristik eines CCD-Registers unter verschiedenen Parametern bestimmt und ein Minimum an Raum auf dem Halbleiter belegt.

Die Aufgabe der vorliegenden Erfindung besteht darin, eine Prüfschaltung zu schaffen, mit der der zulässige kleinste Isolationsabstand zwischen benachbarten CCD-Kanälen in einer planaren integrierten Schaltung bestimmt und der Wirkungsgrad der Ladungsübertragung sowie die Ladungsleckcharakteristik unter verschiedenen Prüfbedingungen gemessen werden können.

Die erfindungsgemäße Lösung ergibt sich aus dem Kennziechen des Patentanspruchs 1.

Weitere erfindungsgemäße Ausführungen sind in den Ansprüchen 2 und 3 charakterisiert.

Durch die vorgeschlagene Erfindung erhält man eine sehr genaue technische Analyse mit einer Prüfschaltung, die relativ wenig Platz auf der Halbleiterfläche erfordert. Die Abfühlung erfolgt vorzugsweise durch einen Linearverstärker, der ein analoges Signal am Ausgang abgibt, wodurch die Verstärkung mit einem Hochleistungsverstärker möglich wird, um detaillierte statistische Daten über den Übertragungswirkungsgrad, die Fehlergröße und andere Merkmale an jedem einzelnen Potentialtopf zu bekommen. Durch Verfolgen der Ladungspakete kann ein kontinuierlicher Strom von Ladungspaketen über längere Zeit unter Änderung einer Vielzahl verschiedener Parameter analysiert werden, wie z.B. Änderung der Amplitude, der Häufigkeit der Phasentakte usw.

Ein Ausführungsbeispiel der Erfindung ist in den beigefügten Zeichnungen dargestellt und wird anschließend näher beschrieben.

Fig. 1 in einem Blockdiagramm schematisch die Erfindung,

Fig. 2 in einem Blockdiagram schematische die Arbeitsweise der Erfindung,

Fig. 3 eine Draufsicht auf eine Halbleiterfläche,

Fig. 3A eine Schnittansicht entlang der Linie 3A in Fig. 3, und

Fig. 3B eine Schnittansicht entlang der Linie 3B in Fig. 3.

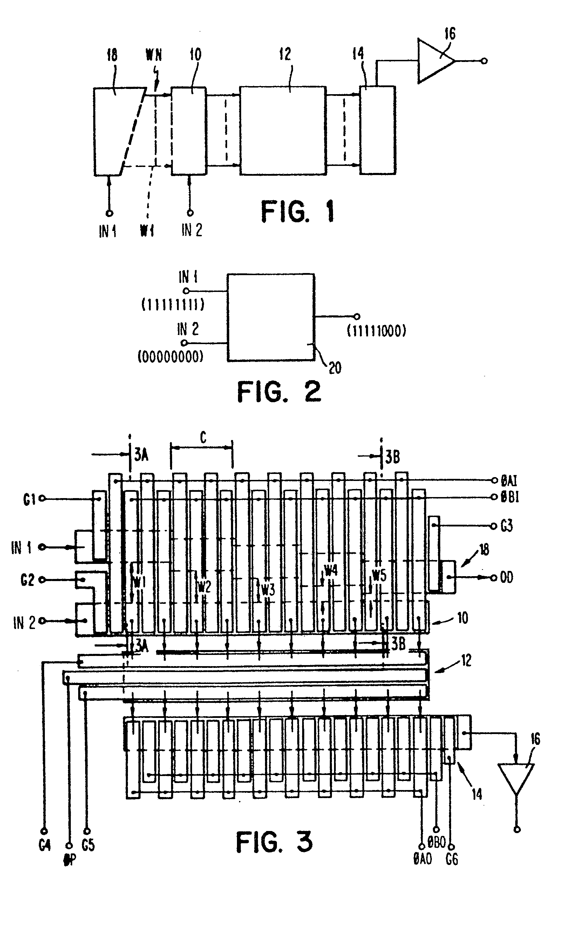

In Fig. 1 ist in Form eines schematischen Blockdiagrammes die erfindungsgemäße Prüfschaltung gezeigt, die man am besten zuerst als herkömmliche SPS-Konfiguration betrachtet. Eine solche SPS-Konfiguration enthält ein serielles Eingaberegister 10, ein Parallelteil 12 und ein serielles Ausgaberegister 14. Ein Eingangsanschluß überträgt Datenbits seriell in das serielle Register 10 bis dieses gefüllt ist. Dann wird der Inhalt des Registers 10 parallel in den parallelen Teil 12 übertragen. Halbleiterstrukturen zur Erzielung von Verbesserungen, wie verschachtelter SPS-Betrieb usw. sind allgemein bekannt und brauchen hier nicht näher beschrieben zu werden. Die vorliegende Erfindung läßt sich auf alle diese Typen von SPS-Konfigurationen anwenden. In die erste Spalte des parallelen Teiles 12 übertragene Daten werden dann parallel durch den Teil 12 und in das Ausgaberegister 14 übertragen. Das serielle Ausgaberegister 14 gibt dann die Datenbits seriell in einen Verstärker 16 aus, der eine binäre Ausgabe an den Ausgangsanschluß liefert. Verschiedene Verstärkerkonfigurationen für die Übernahme der Funktion des Verstärkers 16 sind allgemein bekannt. Grundsätzlich fühlt der Verstärker 16 die Ladung am Ausgang des seriellen Registers 14 ab. Diese Ladung ist nicht immer eine volle binäre Eins oder Null, hat aber unterschiedbare analoge Signalpegel, entsprechend den herkömmlichen Eingabe-Schwellwertmöglichkeiten in einem Verstärker 16. In herkömmlichen SPS-Sperichersystemen wandelt der Verstärker 16 diese Ladungssignalpegel in volle Binärwerte um. Bei einer Anzahl von Anwendung wird die Ausgabe des Verstärkers 16 auf den Eingangsanschluß des seriellen Eingaberegisters 10 zurückgeführt.

Erfindungsgemäß ist ein zusätzliches serielles CCD-Register 18 vorgesehen, das jedoch vom Register 10 in unterschiedlichem Abstand angeordnet ist. Der Isolationsbereich, auch Kanalstop genannt, ist an den Eingangspositionen des Registers 10 und 18 sehr groß gestaltet (W1) und wird dann progressiv kleiner. Wo der Abstand zwischen den Registern 10 und 18 am kleinsten ist (WN), findet mit Sicherheit eine Ladungsübertragung zwischen den beiden Registern statt. Wenn also in die letzte Position des Registers 18 eine binäre Eins zu setzen ist, während in der letzten Position des Registers 10 eine binäre Null steht, dann würde das Übersprechen zu einem Ladungsausgleich führen und eine Bestimmung der Daten verhindern, die in der letzten Position des Registers gespeichert waren.

In der Praxis führt jedoch der Abstand des Registers 18 zum Register 10 auch zu Ladungs-übertragungen (und demzufolge Datenverlust) in einer oder mehreren mittleren Positionen des Registers 10. Auch wenn die in Fig. 1 gezeigte Konfiguration ein Prüfstand ist, hat der parallele Teil 12 nur eine ausreichende Anzahl von Stufen, um die parallele Übertragung vom Register 10 zum Register 14 vorzunehmen. Eine erste Stufe im parallelen Teil 12 kann z.B. die Information vom Register 10 empfangen, eine zweite Stufe im parallelen Teil 12 kann als Übertragungsstufe wirken, während eine dritte Stufe im parallelen Teil 12 als Ausgabestufe zum Register 14 wirken kann. Darin liegen die Unterschiede zu einem herkömmlichen SPS-Speicher, in dem ein paralleler Teil 12 typischerweise hunderte von Stufen haben kann.

In Fig. 2 ist die Prüfschaltung 20 in Blockform dargestellt, die in Fig. 1 insgesamt gezeigt ist. Die seriellen Register 18, 10 und 14 wurden zur Illustration mit einer Speicherkapazität von acht Bits dargestellt. Um den Prüfstand 20 zu betreiben, wird eine Reihe binärer Einsen an den Eingangsanschluß 1 und gleichzeitig eine Reihe binärer Nullen an den Eingangsanschluß 2 angelegt. Das Register 18 empfängt also alle Einsen während das Register 10 alle Nullen empfängt. In Oberflächenkanal-CCDs enthalten binäre Nullen vorzugsweise Hintergrundladungen (fette Nullen), die ausreichen, um die Majorität der Oberflächenzustände zu unterdrucken. Bei abnehmendem Abstand zwischen den Registern 18 und 10 nimmt die Störlanungsübertragung zwischen den Potentialtöpfen der beiden Register zu, bis die Ladungspegel in entsprechenden Bitpositionen der Register 18 und 10 zum Ausgleich neigen. Das Ausmaß des Ladungslecks (Ausgleich) ist eine Funktion der Zeit und der Taktfrequenz, die die Dauer steuert, in der die Ladungslecks auftreten. Wenn alle acht Bitpositionen im Register 10 gefüllt wurden, werden die Daten parallel in das Register 12 und hinterher in das Register 14 übertragen. Die Daten werden dann vom Register 14 durch den Verstärker 16 seriell ausgelesen.

Im gegebenen Beispiel lag die letzte Position der Register 18 und 10 dicht genug bei-eieinander, damit eine nennenswerte Ladungs-menge, die das Einerbit im Register 18 enthielt, in das Register 10 lecken konnte. Diese schließlich durch den parallelen Teil 12 in das Ausgaberegister 14 übertragene Ladung führt zum Auslesen einer binären Eins als erstes Bit vom Verstärker 16. Im vorliegenden Beispiel tritt ein Ladungsleck zwischen den Registern 18 und 10 auch in vier weiteren Bitpositionen vor der letzten Bitposition auf, so daß fünf binäre Einsen vom Verstärker 16 aus gelesen werden, bevor die drei Nullen gelesen werden. In diesem Beispiel ist der Abstand zwischen den Registern 18 und 10 daher für die ersten drei Bitpositionen ausreichend, für die übrigen fünf Bitpositionen aber nicht.

Eine solche Prüfschaltung ist nicht nur während der Entwicklung von CCD-Speichern vorteilhaft, sondern kann auch in produzierten CCD-Speichern eingebaut werden. Da die Prüf-schaltung dieselben Prozeßvariationen auf-weist wie der übrige Halbleiterwafer oder das Chip, ergeben sich beachtliche Steigerungen der Zuverlässigkeit und des Ausstoßes.

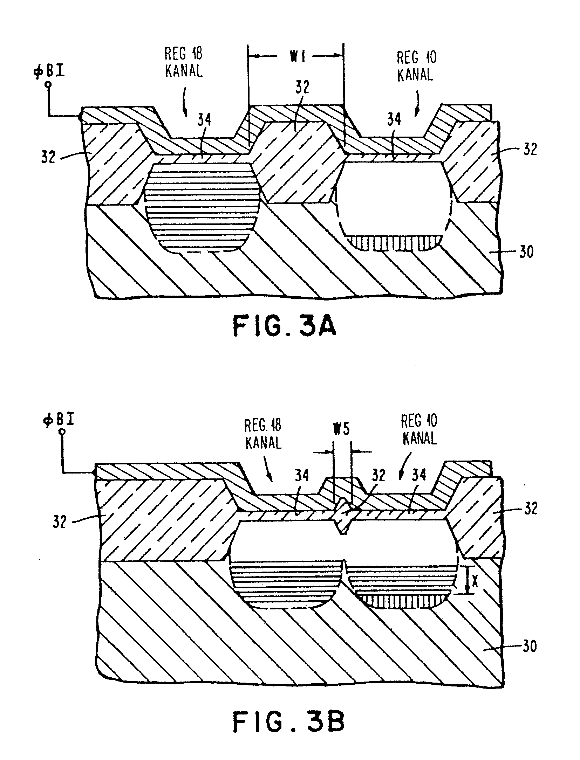

In Fig. 3 ist ein Ausführungsbeispiel der Prüfschaltung gezeigt. Das serielle Eingaberegister 10, der parallele Teil 12 und das serielle Ausgaberegister 14 sind ebenso herkömmlicher Art wie der Verstärker 16. Das eingaberegister 10, das Ausgaberegister 14 und das in schrittweise verändertem Abstand angeordnete serielle Register 18 wurden jeweils 10 Bits lang gemacht. Dargestellt ist eine zweiphasige Anordnung mit zwei Toren, worin der Speicher- und der Übertragungsbereich unter den einzelnen Toren so angeordnet sind, daß die Ladung nach rechts weitergeleitet wird. Die Leitrichtung wird festgelegt durch die strukturelle Asymmetrie, wie etwa ein Versetzungstor oder eine Ionen-implantation. Eine Bitposition besteht aus einem Tor ØA und einem benachbarten Tor ØB. Das erste Tor ØA (auf der linken Seite) hat keinen Übertragungsbereich, sondern dient als Meßtor.

Die Ladungsübertragung zwischen dem Register 18 und dem Register 18 erfolgt durch Ladungsleckausgleich, worin die Ladung über die durch den defekten oder unzureichenden Kanalstop gebildete untere Barriere übertragen wird. Die schrittweise Abstandsveränderung des Registers 18 wurde so ausgelegt, daß sie vier Speicherpositionen lang ist, wie es bei C dargestellt ist. In der gezeigten Anordnung kann bei jedem Schrittabstand eine Ladungsübertragung von maximal zwei Bits vom Register 18 zum Register 10 erfolgen. Dadurch wird die Zuverlässigkeit der durch die Erfindung erzielten Ergebnisse erhöht. Die Zuverlässigkeit wird weiter erhöht durch viele Bitpositionen an jeder fixen Trennstelle W mit einer statistischen Analyse der unterschiedlichen Beträge der übertragenen Ladung.

Der erste Eingangsanschluß IN 1 ist mit einem Eingangselement des Registers 18 verbunden. Ein zweiter Eingangsanschluß ist mit einem Eingangselement des Registers 10 verbunden. Im Betrieb wird der Anschluß G1 mit dem Potential für ein Einerpaket der Signalladung gepulst, die in die Messung unter dem ersten Tor ØAI zu injizieren ist. Wenn der Takt ØAI hochgeht, wird der Eingang IN 1 niedrig gepulst, so daß die Ladung über den Potentialpegel von G1 in den Meßtopf unter dem ersten Tor ØAI fließen kann. IN 1 wird dann hochgepulst, um die Ladungsinjektion abzuschalten und eine Elektronensenke zu bilden, um aus dem ersten Meßtopf über die Potentialbarriere des Tores G1 zu kommen, wenn der Meßtopf überfüllt ist. ØBI wird hoch gepulst und G1 niedrig gepulst, um für alle Ladungen eine Barriere nach links zu bilden. Das Tor ØAI wird dann niedrig gepulst, so daß die Ladung im Meßtopf und alle Speicherladungen unter den Elektronen ØAI Ladung über die Barrieren ØBI in die Speichertöpfe ØBI geben können. Derselbe Vorgang ist zum Speichern eines Null-Signales im Register 10 erforderlich, jedoch wird hier G2 auf den Potentialpegel gepulst, der ein eine Null darstellendes Ladungspaket in den Meßtopf laufen läßt. Die Ladungsmenge kann eine satte Null oder auch gar keine Ladung sein. Bei der sog. Füll- und Auslauftechnik können die Anschlüsse IN 1 und IN 2 zur gleichzeitigen Ladungsinjektion in die Register 18 und 10 verbunden sein.

Die gezeigten Elektroden sind auf bekannte Art aus dotiertem Polysilicium oder Metall hergestellte Leiter. Da dieselbe Metallelektrode über beide Register 18 und 10 läuft, werden Bits unter identischen Phasenelektroden gehalten. Es ist üblich, die Elektroden durch eine dünne Oxidschicht von der darunterliegenden Halbleiterfläche in den aktiven Bereichen der Register 18 und 10 zu trennen. In dem Raum zwischen den Registern 18 und 10 trennt eine dickere Oxidschicht die Register und verbindery so eine Beeinflussing der Ladung in diesen Kanalstop-Bereichen auf dem Substrat durch die Phasentaktsignale. Bei W1 sind somit die Register 18 und 10 durch die Tatsache getrennt, daß die Elektroden vom Substrat durch eine dicke Oxidschicht in dem mit W1 bezeichneten Bereich getrennt sind. In dem mit W2 bezeichneten Bereich liegt unter dem zweiten Satz von vier Elektroden ein kleinerer Abschnitt des dickeren Oxids und der aktive Bereich des dünnen Oxids des Registers 18 wurde effektiv dichter um einen Schrittbetrag an das Register 10 herangeführt. Bei W3, W4 und W5 wurde der Abstand zwischen den Registern 18 und 10 darstellungsgemäß noch weiter eingeengt. Um eine Ansammlung von Ladungen in der letzten Bitposition des Registers 18 zu verhindern, wird an den Anschluß G3 und seine entsprechende Elektrode ein Leitsignal angelegt, um die Ladung an ein Ausgabegerät zu übertragen, wo sie entweder am Anschluß OD durch herkömmliche Schaltungen abgefühlt wird oder abgeleitet wird.

Nachdem das Register 10 gefüllt ist, können die darin befindlichen Ladungspakete über den Anschluß G4 in den parallelen Teil übertragen werden. So werden 10 Bits parallel vom seriellen Register 10 in den parallelen Teil 12 übertragen. Ein Phasenimpuls ØP, angelegt an den angegebenen Anschluß, bringt die Datenbits unter die zweite Elektrode im parallelen Teil, während der Leitimpuls am Anschluß G5 die Ausgabeleitung in das serielle Ausgaberegister 14 besorgt. Das serielle Ausgaberegister 14 ist genau so lang wie die Register 10 und 18 und ist ebenfalls zweiphasig. Die beiden Phasenausgangs-Taktimpulse ØAO und ØBO, angelegt an die entsprechend bezeichneten Anschlüsse, schieben die Daten seriell durch das Ausgaberegister 14. Die Daten werden unter Steuerung eines Leitimpulses ausgeschoben, der an den Anschluß G6 angelegt wird, von wo die Daten durch ein Ausgabegerät (betrachtet als Teil des Abfrageverstärkers 16) geleitet werden, das die Ladung abfühlt. Durch Verfolgung der aus dem Ausgaberegister 14 ausgelesenen Bitgruppen läßt sich bei unterschiedlichen Parametern über längere Zeit ein kontinuierlicher serieller Bitstrom überwachen.

Fig. 3A zeigt ein Schnittansicht entlang der Linie 3A in Fig. 3. Das Halbleitersubstrat 30 kann mit N-leitenden oder P-leitenden Verunreinigungen dotiert werden, abhängig davon, ob eine CCD-Schaltung mit N-Kanal oder P-Kanal gewünscht wird. Die Kanäle sind voneinander durch dicke Oxidbereiche 32 isoliert. Über den Kanalbereichen liegt das dünne Toroxid 34. Die mit dem Anschluß ØBI verbundene Torelektrode liegt über der Struktur und wird auf herkömmliche Weise aus stark dotiertem Polysilicium oder Metall hergestellt. Bis hierher unterscheidet sich die gezeigte Struktur nicht von herkömmlichen Strukturen, in denen mehrere serielle CCD-Register parallel angeordnet werden. Der Abstand W1 reicht aus, um ein Ladungsleck vom Kanal des Registers 18 zum Kanal des Registers 10 zu verhindern. Die Ladung eines binären Einer-Signales ist in das Register 18 injiziert dargestellt, während in den Kanal des Registers 10 die Ladung für ein binäres Null-Signal injiziert wurde. Der kleine Ladungsbetrag im Kanal des Registers 10 ist die satte Null-Ladung, die üblicherweise in die CCD-Zellen des Oberflächenkanales injiziert wird und als binäre Null erkannt wird. Die vorliegende Erfindung läßt sich gleicherweise aber auch bei vergrabenen CCD-Kanälen anwenden, in denen im allgemeinen keine satte Null gebraucht wird und eine binäre Null durch das Fehlen einer Ladung im Potentialtopf dargestellt werden kann. Nach dem Erfindungsgedanken braucht man nicht unbedingt binäre Einer- und Null-Pegel zu benutzen, sondern es reichen für die Prüfungsanalyse unterscheidbare Ladungsdifferenzen.

Fig. 3B zeigt eine Schnittansicht entlang der Linie 3B in Fig. 3. An diesem Punkt wurden der Kanal für das Register 18 und der Kanal für das Register 10 beträchtlich näher zusammengebracht. Sie sind nur durch den Abstand W5 voneinander getrennt. Dadurch kann darstellungsgemäß ein beträchtliches Ladungsleck zwischen den beiden Kanälen auftreten. Die vom Register 18 auf das Register 10 gekoppelte überschüssige Ladung ist mit X bezeichnet. Der angegebene Gesamtladungsbetrag im Register 10 (die erste satte Null-Ladung und die vom Register 18 kegoppelte überschüssige Ladung) wird parallel in den parallelen Teil 12 und seriell aus dem Register 14 übertragen. Die Ausgabe des Registers 14 wird dann von Verstärker 16 abgefühlt.

Wie oben schon gesagt wurde, erfolgt die Abfühlung mit einem herkömmlichen Verstärker. Für die vorliegende Erfindung erfolgt die Abfühlung vorzugsweise durch einen Linearverstärker, der ein analoges Ausgangssignal gibt. Dadurch ist eine nachfolgende Verstärkung mit einem Hochleistungsverstärker möglich, um detaillierte statistische Daten über den Übertragungswirkungsgrad, die Fehlergröße und andere Merkmale an jedem einzelnen Potentialtopf zu bekommen. Durch Verfolgung der Ladungspakete kann ein kontinuierlicher Strom von Ladungspaketen über längere Zeit unter einer Vielzahl verschiedener Parameter analysiert werden. Amplitude und Häufigkeit der Phasentakte können verändert werden. Die Signalgröße der binären Einsen und Nullen, die eingegeben werden, kann ebenso verändert werden, wie die Temperatur und die Substratvorspannung sowie andere Versorgungspotentiale. Auf diese Weise erhält man eine genaue technische Analyse mit einer Prüfschaltung, die relativ wenig Platz auf der Halbleiterfläche belegt.

Als Alternative zur analogen Abfühlung kann auch ein CCD-Abfrageverstärker verwendet werden, der volle binäre Ausgangspegel liefert. Für die vorliegende Erfindung würde die Schwellwertspannung eines solchen Verstärkers etwas oberhalb des Pegels für die satte Null angesetzt. Schwellwerte solcher Verstärker stellt man ein durch Veränderung des Widerstandsund des Kapazitalswertes sowie des aus Referenzspannung angelegten Potentiales.

Ein Beispiel für Abfrageverstärker, die die Ausgangssignale von Ladungskopplungszellen verstärken, finden sich in "Basic Concepts of Charge-Coupled Devices", RCA Review, September 1975, Volume 36, No. 3, besonders auf den Seiten 586 bis 592. In den dort beschriebenen beiden Ausgabetechniken wird zuerst ein Verstärker beschrieben, wie er hier in Fig. 3 gezeigt ist. Abhängig von der gewünschten Empfindlichkeit der Ladungsabfühlung läßt sich aber auch ein Verstärker mit gleitendem Gate verwenden, wie er im einzelnen auf der Seite 589 der angegebenen Literaturstelle beschrieben wird. Die beschriebene SPS-Konfiguration, in der ein zusätzliches Register mit variablem Abstand vom seriellen Eingaberegister vorgesehen ist, stellt jedoch keinerlei Einschränkung auf eine bestimmte Technologie, ein Ausgabegerät oder einen Abfrageverstärker dar.

Eine erfindungsgemäße Prüfschaltung läßt sich natürlich auch für vergrabene Ladungskopplungs-Speicherzellen (BCCD) sowie für Mehrstufenspeicher (MLS) anwenden. In einem MLS kann eine Anzahl von Bits an derselben Bitposition gespeichert werden, indem man verschiedene Schwellenwerte mit einem Verstärker auf geeignete Weise abfühlt. Überschüssige Ladung kann auch hier durch die erfindungsgemäße Prüfschaltung abgefühlt werden.

**Patentansprüche**

1. Prüfschaltung zur Bestimmung des Isolationsabstands zwischen benachbarten Kanälen einer auf einem Substrat integrierten CCD-Speicherschaltung (20), welche ein von einem Datenbitstrome beaufschlagtes serielles Eingabe-Schieberegister (10) aus ladungsgekoppelten Speicherbereichen, ein Speicherregister (12) aus einer Anzahl von parallel zueinander angeordneten seriellen Registern aus ladungsgekoppelten Speicherbereichen, ein serielles Ausgabe-Schieberegister (14) aus ladungsvekoppelten Speicherbereichen sowie Takteinrichtungen (ØAI, ØBI, ØP, ØAO, ØBO) zur Steuerung der Dateneinspeicherung in das Eingabe-Schieberegister sowie der parallelen Übernahme. Verschiebung und Abgabe der Daten durch das Speicherregister und der seriellen Ausgabe der Daten durch das Ausgabe-Schiebregister aufweist, dadurch gekennzeichnet, daß auf dem Substrat (30) der Speicherschaltung (20) ein ebenfalls von den Takteinrichtungen (ØAI, ØBI, ØP, ØAO, ØBO) gesteuertes und mit Prüfdaten beaufachlagbares zusätzliches serielles Schieberegister (18) aus ladungsgekoppelten Speicherbereichen integriert ist, deren Isolationsabstand zu den Speicherbereichen des Eingabe-Schieberegisters (10) vom ersten zum letzten Speicherbereich der beiden Schieberegister (10, 18) zunehmend kleiner wird.

2. Prüfschaltung nach Anspruch 1, dadurch gekennzeichnet, daß das Eingabe-Schieberegister (10), das Ausgabe-Schieberegister (14) und das in schrittweise verändertem Abstand angeordnete zusätzliche serielle Schiebe-Register (18) eine gleiche Anzahl von Bitpositionen aufweisen, die zweiphasig oder mehrphasig getaktet sind.

3. Prüfschaltung nach Anspruch 1 oder 2, dadurch gekennzeichnet, daß das Eingabe-Schieberegister (10) und das zusätzliche serielle Schieberegister (18) durch eine Oxidschicht (32) getrennt sind, deren Dicke (W1—W5) vom ersten zum letzten Speicherbereich der beiden Schieberegister (10, 18) zunehmend kleiner wird.

**Claims**

1. Test circuit to determine the insulation spacing between adjacent channels of a CCD storage circuit (20) integrated on a substrate, said circuit comprising a data bit stream-applied, serial input shift register (10) of charge-coupled storage positions, a storage register (12) of a number of parallel serial registers of charge-coupled storage positions, a serial output shift register (14) of charge-coupled storage positions, as well as clocks (ØAI, ØBI, ØP, ØAO, ØBO) to control the data input into the input shift register, and for the parallel read-in, shifting and read-out of the data through the storage register, and for the serial output of the data through the output shift register, characterized in that integrated on the substrate (30) of the storage circuit (20) is an additional serial shift register (18), which is controlled by the clocks (OAI, ØBI, ØP, ØAO, ØBO) and applicable with test data, the additional shift register (18) being made of charge coupled storage positions whose insulation spacing from the storage positions of the input shift register (10) progressively decreases from the first to the last storage position of the two shift registers (10, 18).

2. Test circuit as claimed in claim 1, characterized in that the input shift register (10), the output shift register (14), and the additional serial shift register (18) arranged in incrementally variable spacing have an equal number of bit positions of two-phase or multi-phase clocking.

3. Test circuit as claimed in claim 1 or 2, characterized in that the input shift register (10) and the additional serial shift register (18) are separated by an oxide layer (32) whose thickness (W1—W5) from the first to the last storage position of the two shift registers (10, 18) is getting increasingly smaller.

**Revendications**

1. Circuit d'essai pour déterminer l'écartement d'isolation entre des canaux adjacents d'un circuit de mémoire du type CCD (20) intégré sur un substrat, ledit circuit d'essai comportant un registre à décalage d'entrée série (10) ayant des régions de stockage à charges couplées, un flux de bits de donnée étant appliqué audit registre, un registre de stockage (12) composé de plusieurs registres série disposés en parallèle les uns par rapport aux autres et ayant des régions de stockage à charges couplées, un registre à décalage de sortie série (14) ayant des régions de stockage à charges couplées, ainsi que des dispositifs de chronologie (ØAI, ØBI, OP, ØAO, ØBO) pour commander l'emmagasinage des données dans le registre à décalage d'entrée et la réception en parallèle, le décalage et l'émission des données par le register de stockage et l'émission en série des données par le registre à décalage de sortie, ledit circuit d'essai étant caractérisé en ce que l'on a intégré, sur le substrat (30) du circuit de mémoire (20), un registre à décalage série supplémentaire (18) également commandé par les dispositifs de chronologie (ØAI, ØBI, ØP, ØAO, ØBO) et pouvant recevoir des données d'essai, ledit registre comportant ded régions de stockage à charges couplées dont l'écartement d'isolation par rapport aux régions de stockage du registre à décalage d'entrée (10) diminue progressivement de la première à la dernière région de stockage des deux registres à décalage (10), 18).

2. Circuit d'essai selon la revendication 1, caractérisé en ce que le registre à décalage d'entrée (10), le registre à décalage de sortie (14), et le registre à décalage série supplémentaire (18) qui est disposé de façon à ce que l'écartement puisse être varié par incréments ont le même nombre de positions de bit avec une chronologie à deux ou à plusieurs phases.

3. Circuit d'essai selon la revendication 1 ou 2, caractérisé en ce que le registre à décalage d'entrée (10) et le registre à décalage série supplémentaire (18) sont séparés par un couche d'oxyde (32) dont l'épaisseur (W1—W5) diminue progressivement de la première à la dernière région de stockage des deux registres à décalage (10, 18).

FIG. 1

FIG. 2

FIG. 3

1

FIG. 3A

FIG. 3B

2